# EUROPEAN PATENT SPECIFICATION

(11) **EP 0 968 505 B1**
(45) Date of publication and mention of the grant of the patent: **05.01.2005**
(21) Application number: 98909538.5
(22) Date of filing: 18.03.1998
(51) Int. Cl.: H01F 27/28

(54) **STRIPE-LINE INDUCTOR**
STREIFENFÖRMIGER INDUKTOR
BOBINE D'INDUCTANCE EN RUBAN

(30) Priority: 20.03.1997 FI 971180
(43) Date of publication of application: 05.01.2000
(73) Proprietor: Micro Analog Systems OY, 02770 Espoo (FI)
(72) Inventor: SIREN, Esko, FIN-02760 Espoo (FI)
(74) Representative: Äkräs, Tapio
(86) International application number: PCT/FI1998/000239
(87) International publication number: WO 1998/043258

(56) References cited:
- US-A- 5 436 441
- US-A- 5 559 360

## Description

The invention generally relates to a stripe-line inductor comprising one or more stripe-line turns provided into one or more layers of a carrier substrate.

Inductors are fabricated or integrated with different techniques and materials on various substrates. For example, the fabrication technology of integrated circuits may be used to provide a planar inductor in one or several conducting layers. Characteristic of such an inductor is that it consists of multiple turns where parts of successive turns are parallel to one another. Any part of the inductor conductor can cross over another part of the inductor conductor.

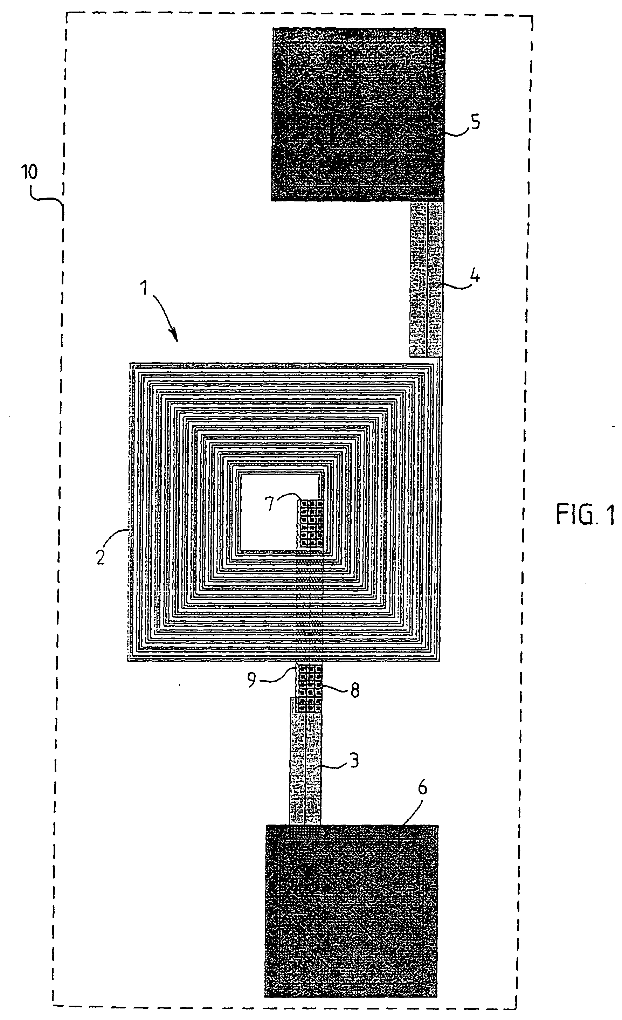

Figure 1 illustrates a prior art inductor. An inductor 1 comprises a stripe-line conductor 2 forming 13 rectangular conductor turns in spiral pattern within each other in a conducting layer of a carrier substrate 10. One end of the stripe-line conductor 2 of the inductor 1 is connected to a terminal 5 by a coupling wire 4. The inner end of the stripe-line 2 is connected by a lead-in 7 to a coupling wire 9 in a second conducting layer of the substrate 10, the coupling wire extending in the second conducting layer from the centre of the inductor 1 to the outside of the inductor. The outer end of the coupling wire 9 is connected by a lead-in 8 to a coupling wire 3 in the same conducting layer of the substrate as the inductor 1. The coupling wire 3 is connected to a second terminal 6.

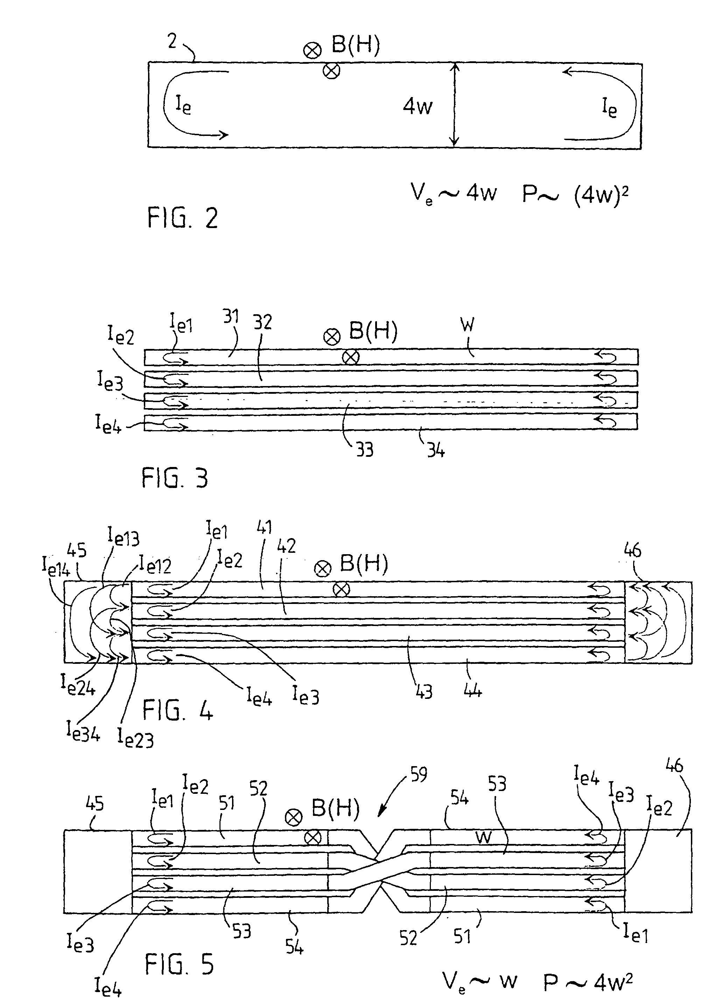

The effect of the multiple turns of the inductor is that a mutual inductance effect through a magnetic field (H) increases the inductance (L) of the inductor. The current in an inductor conductor generates an internal magnetic field in the conductor itself resulting in a current distribution in the conductor, i.e. a skin effect. The magnetic field due to multiple conductor turns is strongest in the centre of the inductor. In addition to the internal magnetic field of the current carrying inductor wire the inductor wire turns are affected by an external magnetic field caused by other layers. The innermost wire turns of the inductor experience the strongest external field. In addition to the mutual inductance effect and the skin effect the magnetic field of the inductor induces an electromotive force and causes eddy currents in the inductor wires and in the conducting layers exposed to the magnetic field. Figure 2 shows a length of a wide stripe-line conductor 2 according to the prior art, affected by a magnetic flux density vector B (unit T = Tesla) caused by the magnetic field of the inductor. The inductor field B induces into the stripe-line 2 eddy currents lₑ, the direction of which is shown by a diagram in Figure 2. One result is that power will be dissipated by the eddy currents lₑ so that the stripe-line 2 causing the magnetic flux density will have greater resistance to alternating current than it would have to direct current. At the same time, the current distribution in the stripe-line 2 changes, since the eddy currents caused by the internal magnetic field of the conductor tend to oppose the main current in the stripe-line 2 and force it near the surface, thus causing the current density to increase towards the surface of the stripe-tine 2. This phenomenon is the above-mentioned skin effect, which becomes more and more significant as the frequency increases, until at relatively high frequencies the current flows almost entirely on a thin "outer surface", whereas the current density in the centre of the conductor is reduced to almost zero. The eddy currents in the stripe-line 2 cause power losses and are seen as a decline in the performance of the inductor, i.e. a reduction of a quality factor (Q) of the inductor. The eddy current increase described above in a conductor loop of the inductor due to the existence of a magnetic field component caused by another conductor loop nearby is also referred to as a "proximity effect".

US-A-5559360 discloses a stripe-line inductor wherein the wire is formed by several substripes. US-A- 5436441 discloses a non-contacting card containing a coil circuit for electromagnetically transmitting electrical power to a terminal and exchanging data between the terminal and the non-contacting card.

An object of the present invention is a stripe-line inductor in which power loss and reduction of a quality factor (Q) caused by eddy currents are significantly smaller than in prior art stripe-line inductors.

This is achieved with the stripe-line inductor according to claim 1.

The amount of power loss caused by the eddy currents or the proximity effect is proportional to a cross-sectional area of the magnetic flux density vector on the stripe-line conductor surface, i.e. the total magnetic flux perpendicular to the conductor surface. Thus, the wider the inductor conductor the greater the induced electromotive force and the eddy current power loss. The stripe-line conductor of the inductor is split into parallel sub-stripe-lines, which reduce the width of an individual conductor and thus the cross-sectional area of the magnetic flux density on the conductor surface. Here parallel means that the sub-stripe-lines are alongside each other and/or one on top of the other. The sub-stripe-lines on a conductor path form a fascicle in which the total cross-sectional area of the sub-stripe-lines in the direction of the conductor path may be of the same size as that of a continuous wide stripe-line conductor in prior art inductors. However, the sub-stripe-lines in a fascicle do not necessarily need to be close to each other. In the invention, each individual narrow sub-stripe-line is affected by a smaller total magnetic flux inducing electromotive force, and smaller eddy currents are generated than in the prior art continuous wide stripe-line conductor. Since the sub-stripe-lines of the invention are as long as the conventional continuous wide stripe-line conductor, the length of the path along which the eddy current flows (and thus the resistance experienced by the eddy current) does not change, and because the induced electromotive force is much smaller, the power loss due to the eddy currents is also significantly smaller.

For providing an inductor conductor corresponding to the conventional wide stripe-line conductor the sub-stripe-lines however, have to be connected together at the fascicle ends. Then a closed loop is formed for the eddy current which results from the electromotive force caused by the magnetic flux density affecting the total area of the fascicle conductor. In other words, as for an external magnetic field the area of the fascicle of stripe-lines connected together at the ends is equal to that of the continuous wide stripe-line conductor. This partly cancels out the effect achieved by a smaller area offered to the induced electromotive force of each stripe-line. However, this advantage is only partially cancelled out, since the magnetic flux density is not constant throughout the entire length of the stripe-line fascicle and thus some eddy current paths in the fascicle parts which are under a weak external magnetic field do not exist. However, to cancel out the closed loop eddy current loss, caused by connecting together the stripe-line fascicle ends, the order of the sub-stripe-lines is reversed or changed in a specific point between the fascicle ends in the present invention. This is done in order to have opposite electromotive forces in the closed loop parts on different sides of a reversing point or a change point in the closed loop formed by the stripes connected together at the fascicle ends. The order may be reversed more than once, which results in the cancellation of many such opposite electromotive forces since their sum is reduced or zero.

Using the inductor of the invention the eddy currents and the eddy current losses can be significantly reduced and the quality factor of the inductor can be increased compared with prior art inductors.

In the following, the invention will be described in greater detail by means of the preferred embodiments with reference to the accompanying drawings, in which
Figure 1 shows a prior art stripe-line inductor,
Figure 2 illustrates a prior art continuous wide conductor stripe and the generation of eddy currents therein,
Figure 3 illustrates a fascicle of stripe-lines and the generation of eddy currents in the stripe-lines.
Figure 4 illustrates a stripe-line fascicle in which the stripe-lines are connected together at the ends and the generation of eddy currents in such a fascicle,
Figure 5 illustrates a stripe-line fascicle in which the stripe-lines are connected together at the ends and in which the order of the stripes is reversed, and the generation of eddy currents in such a fascicle,
Figures 6 and 7 show different stripe-line inductors of the invention.
Figure 8 shows an example of a stripe-line inductor which does not form part of the present invention.

The present invention can be applied to all stripe-line inductors fabricated or integrated into different types of carrier substrates or carrier structures using different manufacturing techniques and materials. The manufacturing techniques may comprise, for example, manufacturing technology of integrated circuits, thin film technology, thick film technology, printed circuit board technology, depositing technology etc. The carrier substrate may, for example, be an integrated silicon chip, a ceramic substrate, a dielectric material, a circuit board etc.

Referring to Figure 2, as noted above, the amount of power loss P due to eddy currents Iₑ or a proximity effect is proportional to the area seen by the external magnetic flux density of the conductor stripe-line 2. For example, in Figure 2 the width of the conductor stripe-line 2 is 4w (w = length unit) and a voltage Vₑ caused by eddy currents is proportional to the width 4w and the eddy current power loss P is proportional to the square (4w)² of the width. This dependence shows that as the width of the conductor increases the induced electromotive power and the eddy current power loss also increase.

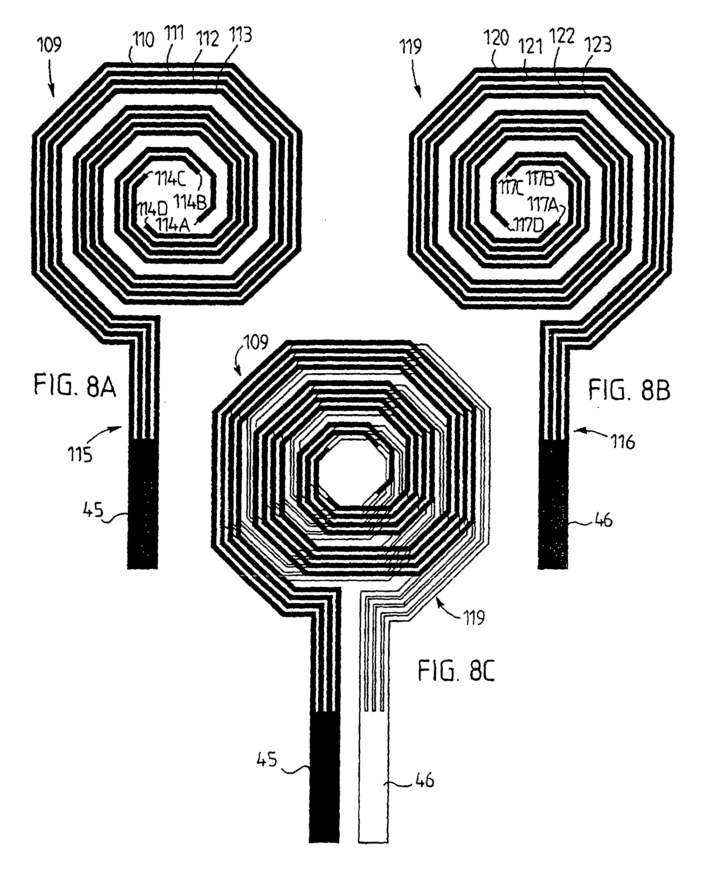

Figure 8 shows a fascicle of conductor sub-stripe-lines. The fascicle comprises four conductor sub-stripe-lines 31, 32, 33 and 34, the width of each one being w (i.e. ¼ of the width of stripe-line conductor 2 in Figure 2). Each conductor sub-stripe-line is affected by a magnetic flux density B generating a corresponding eddy current Iₑ₁, Iₑ₂, Iₑ₃, and lₑ₄ therein. Since the area of an individual conductor sub-stripe-line 31-34 is smaller than the area of the stripe-line conductor 2 in Figure 2, this leads to a smaller inducing electromotive force of the magnetic flux density B and smaller eddy currents in each sub-stripe-line. Furthermore, since the length of the conductor sub-stripe-lines 31-34 is the same as the length of the stripe-line conductor in Figure 2, the length of the path along which the eddy current Iₑ₁-Iₑ₄ has flown and therefore the size of the eddy current power loss resistance does not change, and since the induced electromotive force is much smaller the eddy current loss decreases significantly.

Figure 4 further shows a fascicle of conductor sub-stripe-lines 41, 42, 43 and 44, but now the conductor sub-stripe-lines 41-44 are connected together at the ends by terminals 45 and 46. Again the magnetic flux density B induces the eddy currents Iₑ₁, Iₑ₂, Iₑ₃, and Iₑ₄ to the individual conductor sub-stripe-lines 41-44. As the fascicle in Figure 4 is connected together at the ends, the magnetic flux density B affects the total area of the conductor sub-stripe-lines 41-44, from where the electromotive force to be induced causes eddy currents Iₑ₁₂, Iₑ₁₃, Iₑ₁₄, Iₑ₂₃, Iₑ₂₄, and lₑ₃₄ between the conductor sub-stripe-lines. On account of the closed loop formed by the terminals 45 and 46 the eddy current effect is of the same type as that of the stripe-line conductor 2 in Figure 2. This partly cancels out the advantage obtained from a smaller area of an individual conductor sub-stripe-line. In practical inductor structures a part of the advantage is nevertheless maintained since the magnetic flux density B is generally not constant throughout the length of the entire conductor fascicle 41-44, and on this account all eddy current paths do not exist in those parts of the fascicle which are under a weak magnetic field.

Figure 5 shows a fascicle of conductor stripe-lines 51, 52, 53 and 54, in which the conductor sub-stripe-lines are connected together at the ends by the terminals 45 and 46 in the same way as in Figure 4. However, in Figure 5 the order of the conductor sub-stripe-lines 51-54 is reversed in a specific reversing point 59 along the total length of the fascicle. The order is changed or reversed to accomplish opposite electromotive forces on both sides of the reversing point 59. Consequently, at the different ends of the conductor sub-stripe-line fascicle the electromotive forces coupled from one conductor stripe to another are of opposite signs and cancel out each other, in which case no eddy current is generated. For example, the electromotive force seen in the reversing point to be induced from the conductor sub-stripe-line 51 through the terminal 45 to the conductor sub-stripe-line 54 is of opposite sign than the electromotive force to be induced from the conductor sub-stripe-line 51 through terminal 46 to the conductor stripe-line 54. These electromotive forces cancel out each other. Thus a situation is achieved in Figure 5 where the voltage Vₑ generated by eddy currents is proportional to the width w of an individual stripe-line and the eddy current power loss is proportional to value 4w². Thus a situation corresponding to the ideal case shown in Figure 3 is achieved where the eddy current power losses are only ¼ compared to the stripe-line conductor losses in Figure 2.

Since the inductor of the invention is fabricated or integrated by a patterning and/or deposition technique or by an accurate placement technique, the locations and geometries of conductor materials are well known. The order of the sub-stripe-lines inside the main conductor path, i.e. a set of sub-stripe-lines, can be reversed or changed several times, so that the net value of the electromotive force due to external magnetic flux in any closed loop formed by a pair of stripe-line conductors interconnected at their ends in the stripe-line conductor fascicle is reduced or zero. Here, the extemal magnetic flux stands for magnetic flux generated outside this part of the sub-stripe-line set in another part of the inductor. The sub-stripe-line set can be a bundle, the sub-stripe-lines forming the set being close to each other. Alternatively different stripe-line sets can be intermixed.

When the order of the sub-stripe-lines within the set is reversed and/or changed in such a manner that the total sum of the electromotive forces due to the external magnetic field affecting the eddy current loops of the set is reduced or zero, the internal magnetic field caused by the current of the conductor stripe-line set itself tends to reduce current in those sub-stripe-lines which are close to the axial symmetry line of the reverse and/or change (i.e. in the middle of Figure 5), and to increase current in those stripe-lines in the set which are close to the outside limit of the set. This is known as a skin effect. When the locations and geometries of the conductor material are well known it is possible in addition to reversing and/or changing the order of the sub-stripe-lines within the set for reducing eddy current loss to further change and/or reverse the order of sub-stripe-lines within the set also in such a manner that the electromotive force due to the internal magnetic flux of the set in any closed loop formed from by any pair of sub-stripe-lines connected togetherat their ends in the set is reduced or zero.

In other words, the number and locations of the changes/reverses of the sub-stripe-line order can be designed case-specifically to reduce or to zero one or more of the eddy current loss and the electromotive force as described in the preceding paragraph.

The inductor of the invention may consist of one or more conducting layers in a carrier substrate. These layers are formed using, for example, planar technology, i.e. each conductor material layer is formed when needed. The conducting sub-stripe-lines of the conductor set, or fascicle, are alongside each other and/or one on top of the other. Conductor crossovers are formed in such locations where the conducting stripes reverse and/or change order. The conductor crossovers in the inductor can possibly be performed by changing from one conductor layer to another or by depositing the conductor material and the non-conducting layer simultaneously in the direction of the inductor conductor path.

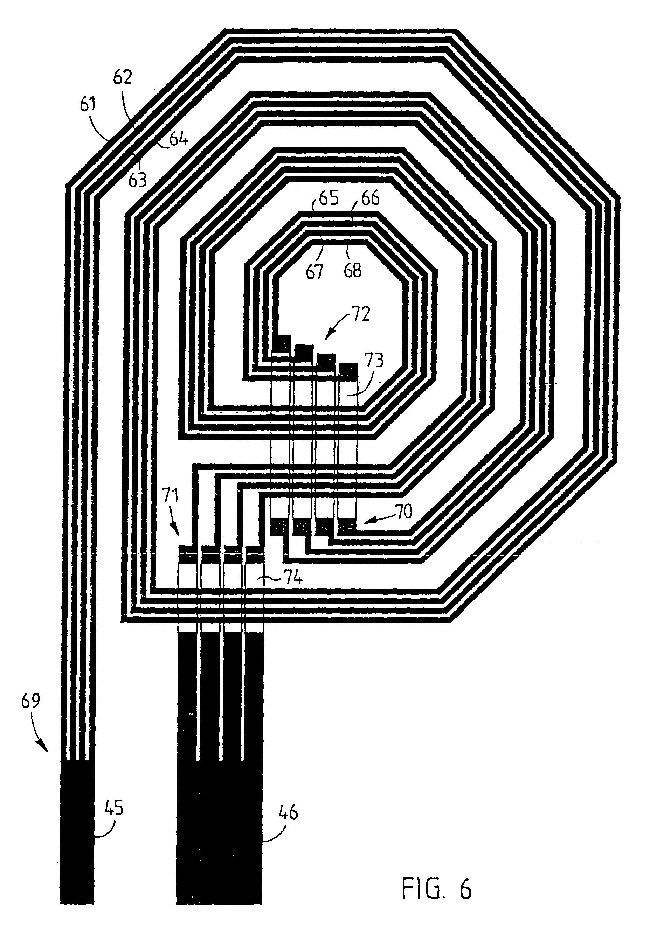

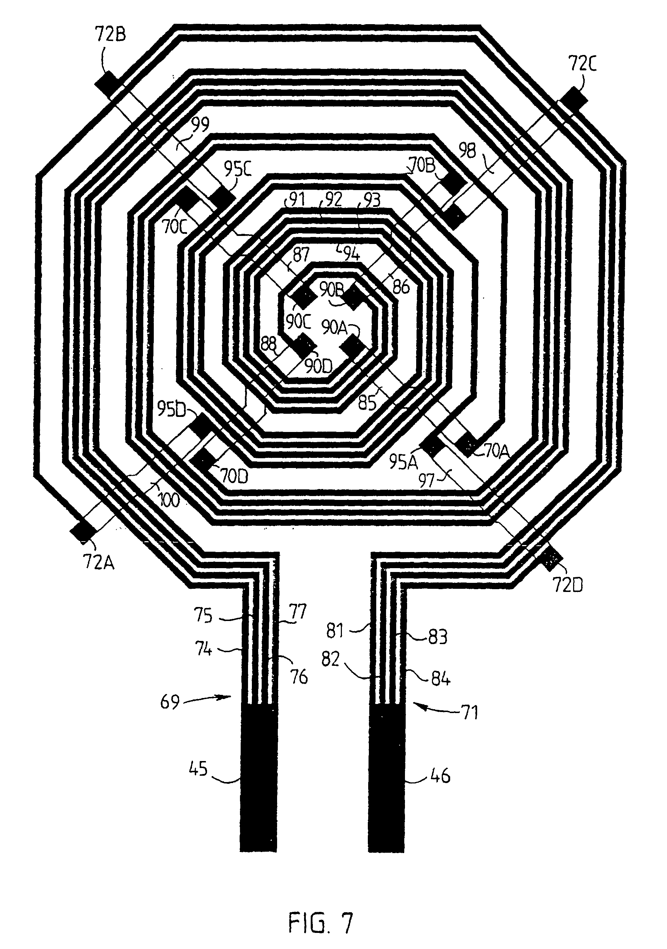

The principal structure of the inductor as used in the invention has been described above. Figures 6 and 7 show examples of such stripe-line inductors implemented in accordance with the invention.

In Figure 6 a first fascicle of sub-stripe-lines 61, 62, 63 and 64 and a second fascicle of sub-stripe-lines 65, 66, 67 and 68 are formed into a conducting layer of the carrier substrate (not shown) Both sub-stripe-line fascicles form approximately two inductor conductor turns within each other. First ends 69 of the fascicle 61-64 are connected to a terminal 45 also connecting the sub-stripe-lines 61-64 together. First ends 71 of the fascicle 65-68 are connected by coupling conductors 74 (in the second conducting layer of the substrate) to a terminal 46 also connecting the sub-stripe-lines 65-68 together. Second ends 70 of the sub-stripe-line conductors 61-64 are connected by coupling wires 73 (in the second conducting layer of the substrate) to second ends 72 of the sub-stripe-lines 65-68 in such a way that the order of the sub-stripe-lines reverses in accordance with the invention. That is, the first (outermost) sub-stripe-line 61 of the first fascicle is connected to the fourth (innermost) sub-stripe-line 68 of the second fascicle. Correspondingly the second (second outermost) sub-stripe-line 62 of the first fascicle is connected to the third (second innermost) sub-stripe-line 67 of the second fascicle. Furthermore the third (second innermost) sub-stripe-line 63 of the first fascicle is connected to the second (second outermost) sub-stripe-line 66 of the second fascicle. Correspondingly the fourth (innermost) sub-stripe-line 64 of the first fascicle is connected to the first (outermost) sub-stripe-line 65 of the second fascicle. Thus, an inductor having low eddy current losses and a high quality factor Q implementing the principle shown in Figure 5 is accomplished.

Figure 7 shows another inductor of the invention comprising a substrate (not shown) in a conducting layer, a first fascicle of sub-stripe-lines 74, 75, 76 and 77, a second fascicle of sub-stripe-lines 81, 82, 83 and 84 and a third fascicle of sub-stripe-lines 91, 92, 93 and 94. First ends of the first fascicle of sub-stripe-lines 74-77 are connected to the terminal 45 and to each other. Correspondingly the first ends of the second fascicle of sub-stripe-lines 81-84 are connected to the terminal 46 and to each other. Second ends 70A, 70B, 70C and 70D of the first fascicle are connected by coupling wires 85, 86, 87 and 88 (in the second conducting layer of the substrate) to first ends 90A, 90B, 90C and 90D of the third fascicle 91-94 in such a manner that the order of the sub-stripe-lines is reversed in a manner according to the invention. Second ends 95A, 95B, 95C and 95 D of the third fascicle 91-94 are in turn connected by coupling wires (in the second conducting layer of the substrate) 97, 98, 99 and 100 to second ends 72A, 72B, 72C and 72D of the second fascicle 81-84 and in such a manner that the order of the sub-stripe-lines reverses again. In this inductor example the stripe-line order is reversed twice between the terminals 45 and 46.

Figures 8A, 8B and 8C illustrate a way by which the inductor can be implemented in the two conducting layers of the carrier substrate. Figure 8A shows a first sub-stripe-line fascicle 109 comprising sub-stripe-lines 110, 111, 112 and 113. First ends 115 of the fascicle 109 are connected to the terminal 45 also connecting the sub-stripe-lines 110-113 to each other. Figure 8B shows a second sub-stripe-line fascicle 119 comprising sub-stripe-lines 120, 121, 122 and 123. First ends 116 of sub-stripe-line fascicle 119 are connected to the terminal 46 connecting the sub-stripe-lines 120-123 to each other. Figure 8C illustrates the inductor where the fascicle 109 is located in the first conducting layer of the substrate and the fascicle 119 is located in the second conducting layer of the substrate. For the sake of clarity Figure 8C does not show the insulating layer of the substrate between the fascicles 109 and 119. Second ends 114A-114D of the fascicle 109 are connected by lead-ins to second ends 117A-117D of the fascicle 119 in such a manner that the stripe-line order is reversed. Thus, an inductor according to the principal in Figure 5 is again obtained.

The invention has above been illustrated by means of some inductor structures. The description above is, however, only meant to illustrate the present invention. Regarding the details the inductor of the invention may vary within the scope of the accompanying claims.

## Claims

1. A stripe-line inductor comprising
two or more stripe-line conductor turns on a carrier substrate (10),
at least one stripe-line conductor of the inductor consisting of two or more sets of parallel and/or overlapping sub-stripe-lines (31-32, 41-42, 51-52, 61-68, 74-77, 81-84, 91-94, 110-113, 120-123) connected together at their ends, and
the order of the parallel and/or overlapping sub-stripe-lines being changed (59) at least once during the total length of said stripe-line conductor, **characterized in that**
said two or more sets of sub-stripe-lines of the inductor are provided within each other in the same layer on the carrier substrate (10), said two or more sets of sub-stripe-lines being connected in series in such a manner that the order of the sub-stripe-lines is changed in every connection point between the sets by means of connections lines (73, 85-88, 97-100) made in another layer on the carrier substrate (10), such that the sum electromotive forces induced in the sub-stripe-lines before the connection point (59) and the electromotive forces induced in the sub-stripe-lines after the connection point is substantially reduced or cancelled.

2. An inductor as claimed in claim 1, **characterized in that** the order of the sub-stripe-lines is reversed.

3. An inductor as claimed in claim 1 or 2, **characterized by**
a first set of parallel sub-stripe-lines (51-54, 61-64, 110-113) in which the sub-stripe-lines are connected together at their first end (45, 69, 115),
a second set of parallel sub-stripe-lines (51-54, 65-68, 120-123) in which the sub-stripe-lines are connected together at their first end (46, 71, 116),
second ends (59, 70, 114A-D) of the first set of sub-stripe-lines being connected to second ends (59, 72, 117A-D) of the second set of sub-stripe-lines in such a manner that the order of the sub-stripe-lines changes.

4. An inductor as claimed in claim 3, **characterized by** the first and second set both comprising N sub-stripe-lines, the order of the first and the second set is connected to reverse in such a manner that sub-stripe-line i in the first set is connected to sub-stripe-line [ N - (i - 1) ] in the second set where i=1,... N and N=1,2,...,.

5. An inductor as claimed in any one of the previous claims, **characterized by** being fabricated by thin film technique, thick film technique, fabrication technique of integrated circuits, printed circuit board technique, deposition technique or any other corresponding technique.

## Patentansprüche

1. Streifenförmiger Induktor aufweisend
zwei oder mehrere Windungen eines Streifenleiters auf einem Trägersubstrat (10),
zumindest einen Streifenleiter des Induktors, der aus zwei oder mehreren Sätzen von parallelen und/oder überlappenden Unterstreifenteilen (31-32, 41-42, 51-52, 61-68, 74-77, 81-84, 91-94, 110-113, 120-123) besteht, die an ihren Enden miteinander verbunden sind, und
wobei die Reihenfolge der parallelen und/oder überlappenden Unterstreifenteile zumindest einmal auf der gesamten Länge des besagten Streifenleiters geändert wird (59), **dadurch gekennzeichnet, dass**
sich die besagten zwei oder mehrere Sätze von Unterstreifenteilen des Induktors ineinander in derselben Schicht auf dem Trägersubstrat (10) befinden, welche besagte zwei oder mehrere Sätze von Unterstreifenteilen derart in Reihe geschaltet sind, dass die Reihenfolge der Unterstreifenteile an jedem Verbindungspunkt zwischen den Sätzen anhand von in einer anderen Schicht auf dem Trägersubstrat vorgesehenen Verbindungsleitungen (73, 85-88, 97-100) geändert wird, so dass die Summe von elektromotorischen Kräften, die in den Unterstreifenteilen vor dem Verbindungspunkt (59) induziert werden, und den elektromotorischen Kräften, die in den Unterstreifenteilen nach dem Verbindungspunkt induziert werden, wesentlich vermindert oder gestrichen wird.

2. Induktor nach Anspruch 1, **dadurch gekennzeichnet, dass** die Unterstreifenteile eine inverse Ordnung aufweist.

3. Induktor nach Anspruch 1 oder 2, **gekennzeichnet durch**
einen ersten Satz von parallelen Unterstreifenteilen (51-54, 61-64, 110-113), in denen die Unterstreifenteile an ihrem ersten Ende (45, 69, 115) miteinander verbunden sind,
einen zweiten Satz von parallelen Unterstreifenteilen (51-54, 65-68, 120-123), in denen die Unterstreifenteile an ihrem ersten Ende (46, 71, 116) miteinander verbunden sind,
wobei zweite Enden (59, 70, 114A-D) des ersten Satzes von Unterstreifenteilen mit zweiten Enden (59, 72, 117A-D) des zweiten Satzes von Unterstreifenteilen derart verbunden sind, dass sich die Ordnung der Unterstreifenteile ändert.

4. Induktor nach Anspruch 3, **dadurch gekennzeichnet, dass** sowohl der erste als auch der zweite Satz N Unterstreifenteile aufweist, die Ordnung des ersten und des zweiten Satzes geschaltet ist, derart invers zu werden, dass der Unterstreifenteil i im ersten Satz mit dem Unterstreifenteil [N-(i-1)] im zweiten Satz verbunden ist, wo i = 1, ...N und N = 1, 2, ... ist.

5. Induktor nach einem der vorhergehenden Ansprüche, **dadurch gekennzeichnet, dass** er mit Dünnfilmtechnik, Dickfilmtechnik, Herstellungstechnik von integrierten Schaltkreisen, Leiterplattentechnik, Abscheidungstechnik oder einer anderen entsprechenden Technik hergestellt wird.

## Revendications

1. Inductance en ruban comportant
deux ou plusieurs spires de conducteur en ruban sur un substrat porteur (10),
au moins un conducteur en ruban de l'inductance consistant en deux ou plusieurs jeux de sous-rubans parallèles et/ou en chevauchement (31-32, 41-42, 51-52, 61-68, 74-77, 81-84, 91-94, 110-113, 120-123) se connectés à leurs bouts, et
l'ordre des sous-rubans parallèles et/ou en chevauchement étant changé (59) au moins une fois au cours de toute la longueur dudit conducteur enruban,**caractérisé en ce que**
lesdits deux ou plusieurs jeux de sous-rubans de l'inductance sont prévus, l'un dans l'autre, dans la même couche sur le substrat porteur (10), lesdits deux ou plusieurs jeux de sous-rubans étant connectés en série de telle manière que l'ordre des sous-rubans est changé à chaque point de connexion entre les jeux à l'aide des conducteurs de connexion (73, 85-88, 97-100) d'une autre couche sur le substrat porteur (10) de sorte que la somme des forces électromotrices induites dans les sous-rubans avant le point de connexion (59) et des forces électromotrices après le point de connexion est sensiblement réduite ou annulée.

2. Inductance selon la revendication 1, **caractérisé en ce que** l'ordre des sous-rubans est inversé.

3. Inductance selon la revendication 1 ou 2,
**caractérisé en ce que**
un premier jeu de sous-rubans parallèles (51-54, 61-64,110-113), dans lequel les sous-rubans se sont connectés à leurs premiers bouts (45, 69, 115),
un deuxième jeu de sous-rubans parallèles (51-54, 65-68, 120-123), dans lequel les sous-rubans se sont connectés à leurs premiers bouts (46, 71, 116),
les deuxièmes bouts (59, 70, 114A-D) du premier jeu de sous-rubans étant connectés aux deuxièmes bouts (59, 72, 117A-D) du deuxième jeu de sous-rubans de sorte que l'ordre des sous-rubans va changer.

4. Inductance selon la revendication 3, **caractérisé en ce que** les premier et deuxième jeux comportent, tous les deux, N sous-rubans, l'ordre du premier et du deuxième jeu est connecté pour être inversé de telle manière que le sous-ruban i du premier jeu est connecté au sous-ruban [N - (i - 1)] du deuxième jeu, où i = 1, ... N et N = 1, 2,...,.

5. Inductance selon l'une quelconque des revendications précedentes, **caractérisé en ce qu'**elle est fabriquée par la technique à couches minces, la technique à couches épaisses, la technique de fabrication à circuits intégrés, la technique pour les cartes de circuits imprimés, la technique de dépôt ou n'importe quelle technique correspondante.
